**Europäisches Patentamt**

(19) **European Patent Office**

**Office européen des brevets**

(11) Veröffentlichungsnummer: **0 001 100 B1**

(12) # EUROPÄISCHE PATENTSCHRIFT

(45) Veröffentlichungstag der Patentschrift:
30.12.81

(51) Int. Cl.³: **H 01 L 21/76,** H 01 L 21/308,
H 01 L 21/32, H 01 L 21/306

(21) Anmeldenummer: **78100804.0**

(22) Anmeldetag: **01.09.78**

(54) Verfahren zum Herstellen von in Silicium eingelegten dielektrischen Isolationsbereichen mittels geladener und beschleunigter Teilchen.

(30) Priorität: **13.09.77 US 832856**

(43) Veröffentlichungstag der Anmeldung:
**21.03.79 Patentblatt 79/6**

(45) Bekanntmachung des Hinweises auf die Patenterteilung:
**30.12.81 Patentblatt 81/52**

(84) Benannte Vertragsstaaten:
**DE FR GB**

(73) Patentinhaber: **International Business Machines Corporation, Armonk, N.Y. 10504 (US)**

(72) Erfinder: **Bondur, James Allen, 117 Walt Street, Walden N.Y. 12586 (US)**
Erfinder: **Pogge, Hans Bernhard, LaDue Road, RD3, Hopewell Junction N.Y. 12533 (US)**

(74) Vertreter: **Oechssler, Dietrich, Dr.rer.nat. Dipl.-Chem., Schönaicher Strasse 220, D-7030 Böblingen (DE)**

(56) Entgegenhaltungen:
DE-A-2 551 961
DE-A-2 643 016
FR-A-2 098 321
US-A-3 966 577
US-A-4 044 452

IBM T. D. B. vol. 20, no. 1, Juni 1977, New York (USA)
J.G. LANE et al.: «Improved E-beam registration mark process», Seite 153

IBM T. D. B. vol. 20, no. 8, Januar 1978, New York (USA)
M.R. POPONIAK et al.: «Forming structures with deep lateral dielectric isolation», Seiten 3074 bis 3075

IBM T. D. B. vol. 20, no. 10, März 1978, New York (USA)
H.-I. STOLLER: «Bipolar integrated circuit devices defined by recessed dielectric isolation of varying depth», Seiten 3901 bis 3902

IBM TECHNICAL DISCLOSURE BULLETIN, vol. 21, no. 3, August 1978, New York
C.G. JAMBOTKAR «Realization of large-value capacitance across base and collector terminals of a bipolar transistor», Seiten 1004 bis 1006

SOLID-STATE TECHNOLOGY, vol. 19, no. 4, May 1976, Washington (USA)
R.L. BERSIN: «A survey of Plasma Etching Processes», Seiten 31 bis 36.

## Verfahren zum Herstellen von in Silicium eingelegten dielektrischen Isolationsbereichen mittels geladener und beschleunigter Teilchen

Die Erfindung betrifft ein Verfahren von in ein Siliciumsubstrat eingelegten dielektrischen Isolationsbereichen, bei dem durch selektives Ätzen unter Anwendung von geladenen und beschleunigten Teilchen Gräben gleicher Breite und mit im wesentlichen vertikalen Wänden in das Siliciumsubstrat geätzt werden und die Gräben dann mit Isoliermaterial gefüllt werden.

Ein derartiges Verfahren ist aus der US-A-3 966 577 bekannt.

Die eingelegte dielektrische Isolation und insbesondere die eingelegte Siliciumdioxidisolation ist in der Technik zur Herstellung hochintegrierter Halbleiterschaltungen bekannt zum Erzeugen von auf demselben Chip befindlichen und voneinander isolierten Bereichen, beispielsweise zum Trennen von Basis- und Kollektorkontaktbereichen bipolarer Transistoren, welche innerhalb der isolierten Bereiche gebildet worden sind, und zum Isolieren von Leiterzügen von dem darunterliegenden Siliciumsubstrat. Es ist auch bekannt, dass eine eingelegte dielektrische Isolation erzeugt werden kann, indem zuerst selektiv Silicium derart von einem Substrat abgetragen wird, dass sich Gräben in dem Substrat bilden und dann die Gräben mit dielektrischem Material gefüllt werden. Ein solches Verfahren ist beispielsweise in dem US-Patent 3 966 577 beschrieben. In diesem Patent wird eine Struktur angegeben, aber über das Verfahren zur Herstellung dieser Struktur wird nur in allgemeinen Ausdrücken gesprochen und es werden keine Einzelheiten über seine Begrenzungen und die einzuhaltenden Bedingungen angegeben.

Um die Fläche auf dem Siliciumchip, welche für die mit dielektrischem Material gefüllten Gräben benötigt werden, auf ein Minimum zu reduzieren, sind Kathodenzerstäubungs-Ätzprozesse und Verfahren zum Abtragen mittels geladener und beschleunigter Teilchen dazu benutzt worden, um die Gräben in dem Siliciumsubstrat zu erzeugen. Ein Abtragungsverfahren mittels geladener und beschleunigter Teilchen ist in der deutschen Offenlegungsschrift 2 617 483 beschrieben. Das in der Offenlegungsschrift beschriebene Verfahren dient dazu, Gräben, welche vertikale Seitenwände aufweisen, herzustellen. Man vermeidet auf diese Weise Nachteile, welche charakteristisch für das chemische Ätzen sind, zu denen insbesondere ein beachtliches Unterätzen der Masken und eine starke Verjüngung der Gräben nach unten gehören.

Es ist die Aufgabe der Erfindung, ein einfaches und schnell durchführbares Verfahren anzugeben, mit dem in ein Siliciumsubstrat eingelegte, unterschiedlich tiefe Isolationsbereiche erzeugt werden, welche ausgezeichnete Isoliereigenschaften haben und deren Oberfläche mit der Oberfläche des Siliciumsubstrats im wesentlichen koplanar sind, ohne dass das «Vogelschnäbel»-Problem auftritt. Unter einem «Vogelschnabel» wird dabei eine mindestens teilweise aus oxidischem Material bestehende Verdickung, in der das Halbleitermaterial bedeckenden Schicht am Rand der eingelegten Isolationsbereiche verstanden.

Diese Aufgabe wird mit einem Verfahren der eingangs genannten Art mit den Merkmalen des kennzeichnenden Teils des Anspruchs 1 gelöst. Aus der DE-A-2 643 016 ist bereits ein Verfahren zum Herstellen von unterschiedlich weit in ein Siliciumsubstrat hineinreichenden eingelegten, mit thermischem Oxid gefüllten Isolationsbereichen bekannt. Jedoch ist es bei diesen Verfahren, wie ein Vergleich der Fig. 5A und 5B zeigt, nicht möglich, unterschiedlich tiefe Gräben innerhalb der selben Zeit vollständig, d.h. dass die Oberfläche des Oxids in den Gräben mit der Oberfläche des Siliciumsubstrats im wesentlichen koplanar ist, mit Oxid zu füllen. Ausserdem wird in der DE-A das Ätzen mittels geladener und beschleunigter Teilchen nicht erwähnt und das Ätzen unterschiedlich tiefer Gräben wird auf anderem Wege als bei dem erfindungsgemässen Verfahren erreicht.

Da das Isoliermaterial aus thermisch gewachsenem Oxid besteht, welches für seine ausgezeichneten isolierenden Eigenschaften bekannt ist, genügen bereits schmale, mittels des erfindungsgemässen Verfahrens hergestellte Isolationsbereiche, um für die meisten Anwendungen eine ausreichende Isolation zu gewährleisten. Dadurch, dass bei den erfindungsgemässen Verfahren möglichst vertikale Grabenwände angestrebt werden, erniedrigt sich der Flächenbedarf, welcher für eine bestimmte Isolierwirkung notwendig ist, weiter. Aus den genannten Gründen ist die Anwendung des erfindungsgemässen Verfahrens gerade auch bei der Herstellung hochintegrierter und dicht gepackter Schaltungen besonders vorteilhaft. Vorteilhafterweise lässt sich das erfindungsgemässe Verfahren beim Vorliegen einer Halbleiterstruktur anwenden, welche aus sich in ihrer Dotierungskonzentration unterscheidenden und übereinanderliegenden Siliciumschichten besteht, indem dann beim Durchätzen der höher dotierten Schichten das Ätzen mindestens einmal während einer auf die Dotierung abgestimmten Zeitdauer unterbrochen wird. Durch diese Massnahme wird ein laterales Ätzen der höher dotierten Schichten verhindert, welches darauf zurückgeführt wird, dass, weil beim Ätzen der höher dotierten Schichten mehr Wärme frei wird als beim Ätzen der nieder dotierten Schichten, sich die höher dotierten Schichten, wenn sie in gleicher Weise wie die nieder dotierten Schichten geätzt werden, relativ stark erwärmen.

Es ist vorteilhaft, wenn die Gräben nicht breiter als $2\,\mu m$ gemacht werden. Dadurch wird sichergestellt, dass die Herstellung der eingelegten Isolationsbereiche innerhalb einer für ein Fabrikationsverfahren vernünftigen Zeit abläuft.

Das erfindungsgemässe Verfahren lässt sich vorteilhaft dann anwenden, wenn mit den Isolationsbereichen einerseits die Kontaktbereiche der Basis und des Kollektors eines bipolaren Transistors und anderseits Chipbereiche, in denen sich voneinander zu isolierende Bauelemente, wie z.B. Transistoren, befinden, voneinander getrennt werden sollen. Man geht bei der Herstellung socher Isolationsbereiche in vorteilhafter Weise von einem Siliciumsubstrat aus, welches aus einer ersten Schicht der einen Leitfähigkeit, einer zweiten darüberliegenden Schicht der anderen, entgegengesetzten Leitfähigkeit mit einer höheren Dotierungskonzentration als die erste Schicht und einer über der zweiten liegenden dritten Schicht vom selben Leitfähigkeitstyp wie die zweite Schicht, aber mit einer geringeren Dotierungskonzentration als diese besteht, und ätzt dann so lang, bis die tieferen Gräben das Substrat bis zur ersten Schicht und die flacheren Gräben das Substrat bis zur zweiten Schicht durchdringen.

Weitere vorteilhafte Ausgestaltungen der Erfindung ergeben sich aus den Unteransprüchen.

Die Erfindung wird anhand von durch Zeichnungen erläuterten Ausführungsbeispielen beschrieben.

Es zeigen:

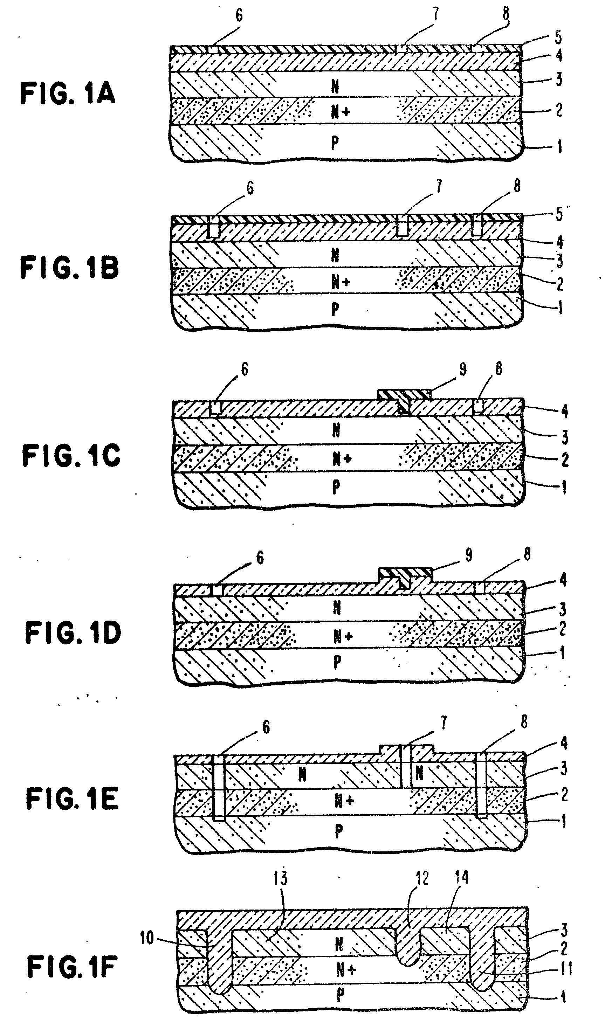

Fig. 1A–1F eine Aufeinanderfolge von vereinfachten Querschnittsansichten einer Halbleiteranordnung, welche verschiedene Stadien der Herstellung von mit dielektrischem Material gefüllten Gräben unterschiedlicher Tiefe gemäss dem erfindungsgemässen Verfahren darstellen.

In der Fig. 1A ist ein Substrat 1 vom P-Typ gezeigt, welches ganzflächig mit einer Schicht 2 vom $N^+$-Typ bedeckt ist, auf welcher eine Schicht 3 vom N-Typ unter Anwendung bekannter Verfahren aufgebracht worden ist. Die Schicht 2 vom $N^+$-Typ dient als Subkollektor von in der Folge herzustellenden vertikalen Bipolartransistoren und als $P/N^+$-Übergangsisolationsteil von mittels eingelegtem Oxid und P/N-Übergängen isolierten Bereichen, welche entsprechend einer Ausführungsform des erfindungsgemässen Verfahrens hergestellt werden sollen. Über der Schicht 3 vom N-Typ ist eine Siliciumoxidschicht 4, welche beispielsweise 500 nm dick ist, aufgebracht. Eine Lackschicht 5, welche Öffnungen aufweist und beispielsweise $2\,\mu m$ dick ist, ist auf der Oberfläche der Oxidschicht 4 aufgebracht. Die Lackschicht 5 kann aus irgendeinem Material bestehen, welches in der Lage ist, dem reaktiven Ionenätzen der darunterliegenden Oxidschicht 4 im Bereich der Öffnungen 6, 7 und 8, welche alle die gleiche Breite aufweisen, zu widerstehen. Das reaktive Ionenätzen wird durchgeführt, indem ein Gasplasma benutzt wird, welches durch eine Hochfrequenzspannung induziert in einer Niederdruckumgebung erzeugt wird, welche mindestens ein Gas, wie z.B. $CF_4$, enthält, welches unter Bildung von Halogenionen oder Radikalgruppen, welche reaktive Halogenionen enthalten, dissoziiert.

Unter Verwendung der mit Öffnungen versehenen Lackmaske 5 wird die Siliciumoxidschicht 4, wie es die Fig. 1B zeigt, teilweise mittels reaktiven Ionenätzens geätzt. Es ist günstig, wenn die Breite der Öffnungen 6, 7 und 8 nicht grösser als ungefähr $2\,\mu m$ ist. Die Lackschicht 5 kann beispielsweise aus dem von der Shipley Corporation unter dem Handelsnamen AZ 1350J vertriebenen positiven Photolack bestehen und kann, wenn dies günstig erscheint, bei Temperaturen bis zu ungefähr 115 °C vor dem reaktiven Ionenätzen nachbehandelt werden. Das reaktive Ionenätzen kann mittels der in der deutschen Offenlegungsschrift 2 617 483 beschriebenen Vorrichtung durchgeführt werden. Geeignete Bedingungen beim reaktiven Ionenätzen sind eine Leistungsdicke von ungefähr 0,32 Watt pro $cm^2$ und eine Fliessgeschwindigkeit des $CF_4$-Gases von 2 bis 3 $cm^3$ pro Min. bei einem Gesamtdruck von ungefähr 53 $\mu$bar (40 $\mu$m Hg 40 microns).

Das reaktive Ionenätzen wird unterbrochen, bevor an den Stellen 6, 7 und 8 die Oxidschicht 4 vollständig durchgeätzt ist. Dann wird, wie es die Fig. 1C zeigt, die Abschirmmaske 9 über der Öffnung 7 aufgebracht. Zur Herstellung der Maske 9 wird bevorzugt dasselbe Lackmaterial wie zur Herstellung der Schicht 5 verwendet. Wenn die Abschirmmaske 9 aufgebracht ist, wird das reaktive Ionenätzen fortgesetzt, bis in den Gräben an den Stellen 6 und 8 die Oxidschicht 4 vollständig durchgeätzt ist. Das Ergebnis dieser Operation zeigt die Fig. 1D.

Das Ätzen wird wieder unterbrochen und anschliessend wird die Abschirmmaske 9 entfernt. Nun wird die Probe in der in der deutschen Offenlegungsschrift 2 617 483 beschriebenen Vorrichtung einem hochfrequenzinduzierten Plasma, welches Chlor und Argon enthält, ausgesetzt. Bevorzugt wird dabei das Silicium mit einer Hochfrequenzleistungsdichte von 0,16 Watt pro $cm^2$ in einer Chlor und Argon enthaltenden Gasmischung, wobei der Chloranteil 3,5% beträgt, bei einem Gesamtdruck von 13,3 $\mu$bar (10 $\mu$m Hg) geätzt. Bei diesem Ätzvorgang wird die Siliciumschicht 3 vom N-Typ wesentlich schneller geätzt als die Siliciumoxidschicht 4. Die Folge davon ist, dass die Gräben an den Stellen 6 und 8 sich schnell durch die Schicht 3 hindurch vertiefen, während gleichzeitig an der Stelle 7 das Siliciumoxid bis zum Silicium weggeätzt wird. Auf diese Weise erhält man die in der Fig. 1E gezeigte Struktur, in welcher die Gräben an den Stellen 6 und 8 die Schichten 3 und 2 durchdringen und sich bis in die Schicht 1 erstrecken, während der Graben an der Stelle 7 nur die Schicht 3 durchdringt und sich bis in die Schicht 2 erstreckt.

Die in der Fig. 1E gezeigte Struktur wird in bekannter Art und Weise thermisch oxidiert, und zwar solange, bis sich durch das Oxidwachstum entlang der vertikalen Wände der schmalen Gräben an den Stellen 6, 7 und 8 die Gräben vollständig gefüllt haben, so dass die in der Fig. 1F gezeigte Struktur entsteht. Es sei besonders darauf hingewiesen, dass der Graben an der Stelle 7 sich trotz der unterschiedlichen Tiefe der Gräben in derselben Zeit mit thermisch gewachsenem Oxid 12 füllt, in welcher die Gräben an den Stellen 6 und 8 mit Oxid 10 und 11 gefüllt werden. Dieses Ergebnis folgt aus der Tatsache, dass alle Gräben die gleiche Breite aufweisen und dass die Gräben in erster Linie dadurch gefüllt werden, dass auf den vertikalen Wänden der Gräben Oxid mit derselben Geschwindigkeit aufwächst.

Der Fachmann wird erkennen, dass die in der Fig. 1F gezeigte Struktur einen Bereich aus N-dotiertem Siliciummaterial enthält, welcher elektrisch von dem Substrat 1 vom P-Typ und von anderen ähnlichen (nicht gezeigten) Bereichen, welche gleichzeitig an anderer Stelle auf dem gleichen Chip erzeugt werden, isoliert ist. Die elektrische Isolation wird bewirkt durch die vertikalen Oxidwände 10 und 11, welche von oben gesehen eine ringförmige oder geschlossene Konfiguration aufweisen, in Kombination mit dem $P/N^+$-Übergang zwischen den Schichten 1 und 2. Der mit Oxid gefüllte Graben 12 dient dazu, den Bereich 13 vom N-Typ von dem Bereich 14 vom N-Typ zu isolieren und um die Bildung von (nicht gezeigten) Basis- und Emitterkontaktstrukturen im Bereich 13 vom N-Typ und einer (nicht gezeigten) Kollektor-Durchreichkontaktstruktur im Bereich 14 vom N-Typ zu erleichtern. Die Bildung dieser Strukturen kann mittels wohlbekannter Verfahren, beispielsweise demjenigen, welches in dem US-Patent 3 648 125 beschrieben ist, durchgeführt werden. Allgemein lässt sich sagen, dass der Abstand zwischen den Oxidwänden 10 und 12 grösser ist als der Abstand zwischen den Oxidwänden 12 und 11, da ein grösseres Gebiet erforderlich ist für den Basis- und den Emitterbereich eines Transistors, welcher im Bereich 13 vom N-Typ gebildet werden soll, als für den Kollektordurchreichbereich, welcher im Bereich 14 vom N-Typ erzeugt werden soll.

Bezüglich des reaktiven Ionenätzens von aufeinanderfolgenden Siliciumschichten mit unterschiedlichen Konzentrationen an Verunreinigungen, wie z.B. der N-dotierten Schicht 3 und der $N^+$-dotierten Schicht 2, ist beobachtet worden, dass die Breite des erzeugten Grabens in stark dotierten Bereichen grösser ist als in den weniger stark dotierten Bereichen. Es wird angenommen, dass dieses Ergebnis darauf zurückzuführen ist, dass sich während des Ätzens der stärker dotierten Schicht eine höhere Temperatur einstellt als während des Ätzens der weniger hochdotierten Schicht. In jedem Fall ist gefunden worden, dass der Unterschied der lateralen Ätzgeschwindigkeiten auf ein Minimum reduziert oder eliminiert werden kann, wenn die Ätzung durch Abschalten (de power) des Plasmagenerators während der Zeit, in der beim Ätzen die stark dotierte Schicht durchdrungen wird, unterbrochen wird. Solch eine «Start–Stop»-Ätzprozedur während des Durchdringens der stärker dotierten Schicht ermöglicht es zu kühlen und es wird dabei ein Graben erhalten, wie z.B. diejenigen, welche sich an den Stellen 6 und 8 in der Fig. 1E befinden, welcher eine im wesentlichen einheitliche Breite vom oberen Rand bis zum Boden aufweist.

**Patentansprüche**

1. Verfahren zum Herstellen von in ein Siliciumsubstrat eingelegten Isolationsbereichen (10, 11, 12), bei dem durch selektives Ätzen unter Anwendung von geladenen und beschleunigten Teilchen Gräben gleicher Breite und mit im wesentlichen vertikalen Wänden in das Siliciumsubstrat geätzt werden und die Gräben dann mit Isoliermaterial gefüllt werden, dadurch gekennzeichnet, dass die Gräben in das Siliciumsubstrat unterschiedlich tief gemacht werden, indem beim Herstellen der Maske (4) für das selektive Ätzen unter Anwendung von geladenen und beschleunigten Teilchen das Ätzen des Maskenmaterials unterbrochen wird, bevor es im Bereich der herzustellenden Fenster ganz weggeätzt ist, indem dann dort, wo flachere Gräben entstehen sollen, die Vertiefungen in der Maske (4) mit einer Abschirmmaske (9) abgedeckt werden, anschliessend in den freiliegenden Maskenöffnungen das Maskenmaterial vollständig entfernt wird, daraufhin die Abschirmmaske (9) entfernt wird, und indem unter Verwendung der dann vorliegenden, auch nicht vollständig geöffnete Fenster aufweisenden Maske (4) das Silicium den geladenen und beschleunigten Teilchen ausgesetzt wird und dass alle Gräben in derselben Zeit vollständig mit thermischem Oxid (10, 11, 12) gefüllt werden, indem in erster Linie auf den vertikalen Wänden Oxid aufgewachsen wird.

2. Verfahren nach Anspruch 1, dadurch gekennzeichnet, dass die Maske (4) für das Ätzen der Gräben aus Siliciumoxid hergestellt wird und dass beim Ätzen des Siliciums mittels reaktiven Ionenätzens gearbeitet wird.

3. Verfahren nach Anspruch 1 oder 2, dadurch gekennzeichnet, dass es beim Vorliegen einer Halbleiterstruktur angewandt wird, welche aus verschiedenen, sich in ihrer Dotierungskonzentration unterscheidenden und übereinanderliegenden Siliciumschichten besteht, und dass beim Durchätzen der höher dotierten Schichten das Ätzen mindestens einmal während einer auf die Dotierung abgestimmten Zeitdauer unterbrochen wird.

4. Verfahren nach einem der Ansprüche 1 bis 3, dadurch gekennzeichnet, dass die Gräben nicht breiter als $2 \mu m$ gemacht werden.

5. Verfahren nach einem der Ansprüche 1 bis 4, dadurch gekennzeichnet, dass die Gräben in ein Siliciumsubstrat geätzt werden, welches aus einer ersten Schicht (1) der einen Leitfähigkeit, einer zweiten darüberliegenden Schicht (2) der anderen entgegengesetzten Leitfähigkeit mit einer höheren Dotierungskonzentration als die erste Schicht (1) und einer über der zweiten liegenden dritten Schicht (3) vom selben Leitfähigkeitstyp wie die zweite Schicht (2), aber mit einer geringeren Dotierungskonzentration als diese, besteht.

6. Verfahren nach Anspruch 5, dadurch gekennzeichnet, dass die tieferen Gräben bis zur ersten Schicht (1) und die flacheren Gräben bis zur zweiten Schicht (2) in das Siliciumsubstrat hineingeätzt werden.

7. Verfahren nach einem der Ansprüche 1 bis 6, dadurch gekennzeichnet, dass die Maske (4) mittels reaktiven Ionenätzens erzeugt wird.

8. Verfahren nach einem der Ansprüche 2 bis 7, dadurch gekennzeichnet, dass das Silicium in einer Chlor und Argon enthaltenden Atmosphäre dem reaktiven Ionenätzen ausgesetzt wird.

### Claims

1. A process for forming insulating regions (10, 11, 12) embedded in a silicon substrate, wherein under the influence of charged and accelerated particles trenches of equal width and essentially vertical walls are formed in the silicon substrate by selective etching through windows in a mask, and thereafter the trenches are filled with an insulating material, characterized in that the trenches in the silicon substrate are formed to different depths by interrupting the etching of the masking material during the production of the mask (4) to be used for the selective etching prior to completely etching away the material in the areas of the windows, subsequently covering the recesses in the mask (4) with a block-off mask (9) at the locations where shallower trenches are to be formed, then completely removing first the remaining masking material in the partially etched mask windows and then the block-off mask (9), exposing the silicon to the charged and accelerated particles through the mask (4) so formed comprising both completely and incompletely opened windows, and simultaneously completely filling all the trenches with thermal oxide primarily grown on the vertical walls.

2. Process as in claim 1, characterized in that the mask (4) for etching the trenches is made from silicon dioxide and that the silicon is etched by means of reactive ion etching.

3. Process as in claims 1 or 2, characterized in that it is applied to a semiconductor structure consisting of several silicon layers overlying each other and having different dopant concentrations, and that the etching process is interrupted at least once during a period adjusted to the dopant concentration while etching through the higher doped layers is performed.

4. Process as in one of the claims 1 to 3, characterized in that the trenches are made not wider that $2 \mu m$.

5. Process as in one of the claims 1 to 4, characterized in that trenches are etched in a silicon substrate consisting of a first layer (1) of a first conductivity type, a second layer (2) overlying the first layer (1) and being of opposite conductivity type and having a higher doping concentration than said first layer (1), and a third layer (3) overlying said second layer (2) and being of the same conductivity type as the second layer (2) but having a lower doping concentration.

6. Process as in claim 5, characterized in that deeper trenches are etched down to the first layer (1) and the shallower trenches are etched down to the second layer (2) in the silicon substrate.

7. Process as in one of the claims 1 to 6, characterized in that the mask (4) is produced by means of reactive ion etching.

8. Process as in one of the claims 2 to 7, characterized in that the silicon is exposed to the reactive ion etching procedure in a chlorine and argon containing atmosphere.

### Revendications

1. Procédé pour former des régions isolantes (10, 11, 12) encastrées dans un substrat de silicium, dans lequel on utilise des particules chargées et accélérées pour réaliser dans le substrat, à l'aide d'un décapage sélectif, des tranchées de largeur égale et dont les parois sont essentiellement verticales qui seront ultérieurement remplies avec un matériau isolant, caractérisé en ce que les tranchées sont réalisées avec différentes profondeurs dans le substrat de silicium, en interrompant le décapage du matériau de masquage dans la fabrication du masque (4), pour un décapage sélectif consistant dans l'application de particules chargées et accélérées avant que le matériau ne soit complètement décapé dans la région des ouvertures à former, en recouvrant ensuite les cavités du masque (4) aux emplacements où des tranchées moins profondes doivent être formées par un masque de blocage (9) et en enlevant successivement, la totalité du matériau de masquage dans les ouvertures de masquage ainsi exposées et le masque de blocage (9), et en soumettant le silicium aux particules chargées et accélérées à travers le masque (4) qui comporte à ce moment des ouvertures inachevées, et enfin en ce que l'on remplit en même temps, complètement, toutes les tranchées avec de l'oxyde thermique (10, 11, 12) en faisant croître l'oxyde surtout sur les parois verticales.

2. Procédé selon la revendication 1, caractérisé en ce que le masque (4) pour décaper les tranchées est composé de dioxyde de silicium; le silicium étant décapé à l'aide d'un procédé de décapage par ions réactifs.

3. Procédé selon la revendication 1 ou 2, caractérisé en ce qu'il est utilisé pour une structure semi-conductrice composée de plusieurs couches de silicium superposées ayant différentes concentrations de dopage et en ce que le processus de décapage est interrompu au moins une fois lors du décapage à travers les couches d'un dopage plus élevé et ceci pendant un intervalle correspondant au dopage.

4. Procédé selon l'une des revendications 1 à 3, caractérisé en ce que la largeur des tranchées ne peut être supérieure à $2 \mu m$.

5. Procédé selon l'une des revendications 1 à 4, caractérisé en ce que l'on décape les tranchées dans un substrat de silicium composé d'une première couche (1) d'un premier type de conductivité, d'une seconde couche superposée (2) de conductivité opposée, ayant une concentration de dopage plus élevée que la première couche (1), et d'une troisième couche (3) superposée sur la seconde couche et du même type de conductivité que la seconde couche (2) mais avec une concentration de dopage plus faible que celle-ci.

6. Procédé selon la revendication 5, caractérisé en ce que l'on décape les tranchées les plus profondes jusqu'à la première couche (1) et les tranchées les moins profondes jusqu'à la seconde couche (2) dans le substrat de silicium.

7. Procédé selon l'une des revendications 1 à 6, caractérisé en ce que l'on produit le masque (4) à l'aide d'un décapage par ions réactifs.

8. Procédé selon l'une des revendications 2 à 7, caractérisé en ce que le silicium est exposé au processus de décapage par ions réactifs dans une atmosphère contenant du chlore et de l'argon.

**FIG. 1A**

**FIG. 1B**

**FIG. 1C**

**FIG. 1D**

**FIG. 1E**

**FIG. 1F**